(19)

Europäisches Patentamt
European Patent Office
Office européen des brevets

(11) **EP 4 616 966 A2**

(12) **EUROPEAN PATENT APPLICATION**
published in accordance with Art. 153(4) EPC

(43) Date of publication:
**17.09.2025 Bulletin 2025/38**

(21) Application number: **23714053.8**

(22) Date of filing: **01.02.2023**

(51) International Patent Classification (IPC):
**B06B 1/06** (2006.01)        **B06B 1/02** (2006.01)
**B23K 20/10** (2006.01)

(52) Cooperative Patent Classification (CPC):
**B06B 1/02; B06B 1/06; B23K 20/10**

(86) International application number:
**PCT/JP2023/003167**

(87) International publication number:
**WO 2023/054733 (06.04.2023 Gazette 2023/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.11.2022 JP 2022178383**

(71) Applicant: **Link-US Co., Ltd.
Yokohama-shi, Kanagawa 222-0033 (JP)**

(72) Inventors:
• **NAKAMURA Yasuhiro
Yokohama-shi, Kanagawa 222-0033 (JP)**
• **YAMAUCHI Motoshi
Yokohama-shi, Kanagawa 222-0033 (JP)**
• **TOMITA Kazumasa
Yokohama-shi, Kanagawa 222-0033 (JP)**
• **SATO Yuichiro
Yokohama-shi, Kanagawa 222-0033 (JP)**

(74) Representative: **Schön, Christoph
Dr. Schön, Neymeyr & Partner mbB
Bavariaring 26
80336 München (DE)**

(54) **ULTRASONIC COMPOSITE VIBRATION DEVICE AND ULTRASONIC BONDING DEVICE**

(57)    There is provided an ultrasonic composite vibration device or the like that is configured by connecting a plurality of vibration elements so that stability of the connection state is improved. A first vibration element 11 and an intermediate vibration element 10 are co-axially connected at one designated connection location which, in a mid-section of an ultrasonic composite vibration device 1, is included in a range within a phase angle of $0.05\,\pi$ based on antinodes A (M1) of a standing wave M1 of the longitudinal vibration, and is included in a range within a phase angle of $0.22\,\pi$ based on nodes N (M2) of a standing wave M2 of the torsional vibration. Similarly, in the mid-section of the ultrasonic composite vibration device 1, the intermediate vibration element 10 and the second vibration element 12 are co-axially connected by a mechanical connection mechanism at another designated connection location.

FIG.2

## Description

Technical Field

The present invention relates to an ultrasonic composite vibration device and an ultrasonic bonding device using the same.

Background Art

A composite vibration element for an ultrasonic processing machine, which obtains in advance a condition in which common node and antinode planes are provided at adjacent resonance frequencies of each of longitudinal vibration and torsional vibration constituting composite vibration, and supports the composite vibration element at the node plane, has been proposed (for example, see Patent Literature 1). As a result, a vibration loss on the support surface is reduced and the positioning accuracy of a distal end is improved while maintaining high stiffness of the composite vibration element.

Citation List

Patent Literature

Patent Literature 1: Japanese Patent No. 5036124

Summary of Invention

Technical Problem

The composite vibration element includes two vibration elements connected at the common node plane at resonance frequencies of longitudinal vibration and torsional vibration. Thus, a relatively large mechanical load is applied to a connection location between the two vibration elements due to the vibration, and there is a possibility that the connection state is unstable.

Therefore, an object of the present invention is to provide an ultrasonic composite vibration device or the like that is configured by connecting a plurality of vibration elements so that stability of the connection state can be improved.

Solution to Problem

An ultrasonic composite vibration device according to the present invention, which is an ultrasonic composite vibration element that induces composite vibration by synthesizing longitudinal vibration and torsional vibration, includes:

a first vibration element having an electrostrictive transducer that generates the longitudinal vibration; and a second vibration element having a slit and a frequency adjustment element for converting the longitudinal vibration into the torsional vibration, in which the first vibration element and the second vibration element are co-axially connected at a first designated connection location which is included in a range within a phase angle of $0.05\,\pi$ based on antinodes of a standing wave of the longitudinal vibration, and is included in a range within a phase angle of $0.22\,\pi$ based on nodes of a standing wave of the torsional vibration, and

the first vibration element or the second vibration element is configured to be supported in a designated support location where a node of at least one of the standing wave of the longitudinal vibration and the standing wave of the torsional vibration is present.

In the ultrasonic composite vibration device according to Claim 1,

it is preferable that at least one of the first vibration element and the second vibration element includes a plurality of vibration elements, and the plurality of vibration elements is co-axially connected at a second designated connection location which is included in the range within the phase angle of $0.05\,\pi$ based on the antinodes of the standing wave of the longitudinal vibration, and is included in the range within the phase angle of $0.22\,\pi$ based on the nodes of the standing wave of the torsional vibration.

In the ultrasonic composite vibration device according to the configuration,

it is preferable that the second vibration element has a shape in which a columnar portion and a cylindrical portion are co-axially continuous at a location which is included in the range within the phase angle of $0.22$ $\pi$ based on the nodes of the standing wave of the torsional vibration, and the slit is provided in the columnar portion in a range within a phase angle of $0.20\,\pi$ based on the nodes of the standing wave of the torsional vibration.

In the ultrasonic composite vibration device according to the configuration, it is preferable that the frequency adjustment element is present behind the slit in the second vibration element.

In the ultrasonic composite vibration device according to the configuration, it is preferable that the node of the standing wave of the torsional vibration is present in the designated support location.

In the ultrasonic composite vibration device according to the configuration, it is preferable that the first vibration element and the second vibration element are co-axially connected at the first designated connection location via an intermediate member.

In the ultrasonic composite vibration device according to the configuration,

it is preferable that the plurality of vibration elements is co-axially connected at the second designated connection location via an intermediate member.

An ultrasonic bonding device according to the present invention includes:

the ultrasonic composite vibration device;
a horn tip attached to a distal end part of the second vibration element; and
an anvil disposed facing the horn tip to support a workpiece serving as a bonding target.

Brief Description of Drawings

FIG. 1 is a configuration explanatory view of an ultrasonic composite vibration device and an ultrasonic bonding device according to a first embodiment of the present invention.
FIG. 2 is an explanatory view of a connection mode of a vibration element constituting the ultrasonic composite vibration device according to the first embodiment of the present invention.
FIG. 3A is a configuration explanatory view of a second vibration element according to the first embodiment.
FIG. 3B is a configuration explanatory view of a second vibration element according to another embodiment.
FIG. 4A is a configuration explanatory view of a second vibration element according to a first modified embodiment.
FIG. 4B is a configuration explanatory view of a second vibration element according to a second modified embodiment.
FIG. 5 is an explanatory view for a relationship between a depth and length of a slit of an ultrasonic composite vibration system and a torsional resonance frequency.
FIG. 6 is an explanatory view of a connection mode of a vibration element constituting an ultrasonic composite vibration device according to a second embodiment of the present invention.
FIG. 7 is an explanatory view of a connection mode of a vibration element constituting an ultrasonic composite vibration device according to a third embodiment of the present invention.
FIG. 8 is an explanatory view of a connection mode of a vibration element constituting an ultrasonic composite vibration device according to a fourth embodiment of the present invention.
FIG. 9 is an explanatory view of a connection mode of a vibration element constituting an ultrasonic composite vibration device according to a fifth embodiment of the present invention.

Description of Embodiments

(Configuration)

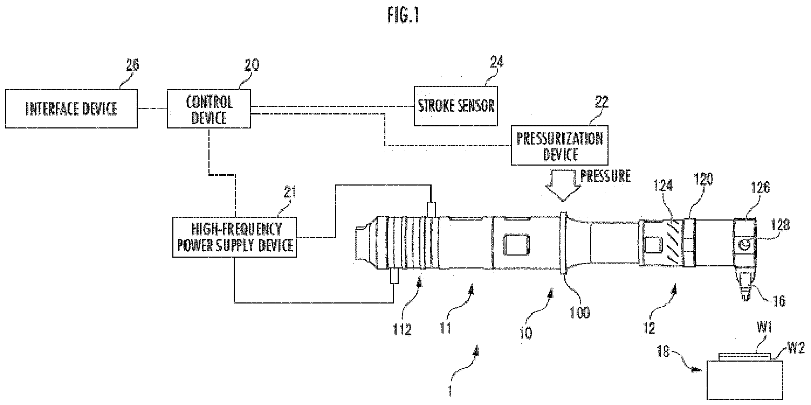

As a first embodiment of the present invention illustrated in FIG. 1, an ultrasonic composite vibration device 1 is a component of an ultrasonic bonding device that bonds workpieces W1 and W2, which are bonding targets, such as a metal plate, using ultrasonic composite vibration to be described later. The ultrasonic bonding device is used, for example, for bonding electrodes of lithium ion batteries and/or semiconductor elements, and the same or different metals.

As illustrated in FIG. 1, the ultrasonic composite vibration device 1 includes a first vibration element 11 having a substantially columnar shape, an intermediate vibration element 10 having a substantially columnar shape, a substantially cylindrical shape, or a substantially bottomed cylindrical shape, and a second vibration element 12 having a substantially cylindrical shape or a substantially bottomed cylindrical shape. The ultrasonic bonding device includes the ultrasonic composite vibration device 1, a horn tip 16, and an anvil 18.

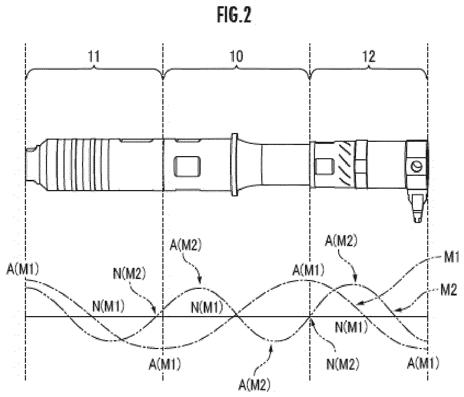

FIG. 2 illustrates a configuration of the ultrasonic composite vibration device 1 and a relationship between a standing wave M1 of longitudinal vibration and a standing wave M2 of torsional vibration, which are generated in the ultrasonic composite vibration device 1. As illustrated in FIG. 2, the ultrasonic composite vibration device 1 is configured such that antinodes A (M1) of the standing wave M1 of the longitudinal vibration are present in each of a rear end surface and a distal end surface of the ultrasonic composite vibration device 1.

As illustrated in FIG. 2, the first vibration element 11 and the intermediate vibration element 10 are co-axially connected by a mechanical connection mechanism (such as a bolt and/or a clamping mechanism) at a designated connection location where, in a mid-section or an intermediate part of the ultrasonic composite vibration device 1, one antinode A(M1) of the standing wave M1 of the longitudinal vibration is present, and which is shifted by a phase angle of $0.05\,\pi$ based on one node N (M2) of the standing wave M2 of the torsional vibration. As illustrated in FIG. 2, the intermediate vibration element 10 and the second vibration element 12 are co-axially connected by the mechanical connection mechanism at a designated connection location where, in the mid-section of the ultrasonic composite vibration device 1, another antinode A (M1) of the standing wave M1 of the longitudinal vibration is present, and one node N (M2) of the standing wave M2 of the torsional vibration is present. The designated connection location is defined as any location which is present in a range within a phase angle of $0.05\,\pi$ based on the antinodes A (M1) of the standing wave M1 of the longitudinal vibration, and is present in a range within a phase angle of $0.22\,\pi$ based on the nodes N (M2) of the standing wave M2 of the torsional vibration.

The intermediate vibration element 10 may be a component of the first vibration element 11. That is, the first vibration element 11 may include two vibration elements. In this case, the first vibration element 11 and the intermediate vibration element 10 may not be mechanically connected, but may be integrally configured.

The intermediate vibration element 10 may be a component of the second vibration element 12. That is, the second vibration element 12 may include two vibration elements. In this case, the second vibration element 12 and the intermediate vibration element 10 may not be mechanically connected, but may be integrally configured.

As illustrated in FIG. 1, the first vibration element 11 is provided with a piezoelectric body 112 that has an axial direction as a piezoelectric polarization direction.

As illustrated in FIG. 1, the intermediate vibration element 10 is formed with an intermediate flange 100 having a substantially annular plate shape, which protrudes in a radial direction over the entire circumference, at an intermediate position of the intermediate vibration element 10 in an axial direction of the intermediate vibration element 10. The intermediate vibration element 10 is configured to be clamped or supported at least at the intermediate flange 100 by a clamping mechanism (not illustrated) over the entire circumference. When it is ensured that the intermediate vibration element 10 is supported by a mechanical support mechanism, the intermediate flange 100 may be omitted. As illustrated FIG. 1, the intermediate vibration element 10 has a substantially cylindrical shape having an outer diameter that is substantially constant in the axial direction behind the intermediate flange 100 (in a left direction in FIG. 1). As illustrated in FIG. 1, the intermediate vibration element 10 has a substantially cylindrical shape (a shape in which a substantially conical frustum shape and a substantially cylindrical shape are co-axially connected) having a substantially constant outer diameter after the diameter is continuously reduced partway toward a distal end part in front of the intermediate flange 100 (in a right direction of FIG. 1).

As illustrated in FIG. 1, the second vibration element 12 is provided with a frequency adjustment element 120 having a substantially regular octagonal shape with rounded corners, which protrudes in the radial direction over the entire circumference, at an intermediate position of the second vibration element 12 in the axial direction of the second vibration element 12. The frequency adjustment element 120 adjusts resonance frequencies of a longitudinal vibration component and a torsional vibration component of ultrasonic vibration.

As illustrated in FIG. 1, the second vibration element 12 has a plurality of slits 124 formed in an outer surface behind the frequency adjustment element 120. The plurality of slits 124 may be formed in the outer surface of the second vibration element 12 in front of the frequency adjustment element 120. In the second vibration element 12, the slit 124 extends obliquely when viewed from a side, or extends in the axial direction while being displaced in a circumferential direction at the same phase. N (N = 2, 3, ...) slits 124 may be disposed to have N-time rotational symmetry (for example, N = 8, 12, or 16) about a central axis of the second vibration element 12.

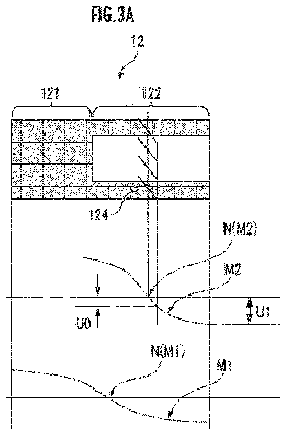

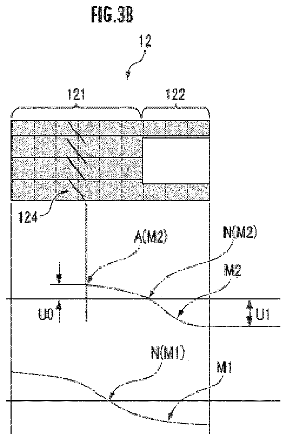

As simply illustrated in FIGS. 3A and 3B, respectively, the second vibration element 12 has a shape in which a columnar portion 121 having a substantially columnar shape and provided on a proximal end side and a cylindrical portion 122 having a substantially cylindrical shape and provided on a distal end side, which has substantially the same diameter as the columnar portion, are co-axially continuous. That is, the second vibration element 12 is formed in a substantially columnar shape in which holes having a substantially columnar shape extending from the distal end side in the axial direction are co-axially provided.

According to one embodiment illustrated in FIG. 3A, a continuous location (bottom part of the hole) of the columnar portion 121 and the cylindrical portion 122 is provided at a location where the antinode A (M2) of the standing wave M2 of the torsional vibration is present. In addition, the slit 124 is provided at the cylindrical portion 122 in a range within a phase angle of $0.16\,\pi$ to $0.22\,\pi$ based on the node N (M2) of the standing wave M2 of the torsional vibration.

According to another embodiment illustrated in FIG. 3B, a continuous location (bottom part of the hole) of the columnar portion 121 and the cylindrical portion 122 is in a range within a phase angle of $0.22\,\pi$ based on the node N (M2) of the standing wave M2 of the torsional vibration. In addition, the slit 124 is provided in the columnar portion 121 in a range within a phase angle of $0.20\,\pi$ based on the antinode A (M2) of the standing wave M2 of the torsional vibration.

In the second vibration element 12, an amplitude amplification ratio (U1/U0), which is a ratio of an amplitude U1 of the torsional vibration at a distal end part 126 of the second vibration element 12 to an amplitude U0 of the torsional vibration at a distal end part of the slit 124, is mainly determined by a ratio of T0 and T1, which are polar moments of inertia of the distal end part of the slit 124 and the distal end part 126 of the second vibration element 12, respectively. Specifically, the smaller T1, the larger the amplitude amplification ratio (U1/U0) of the torsional vibration. Since the second vibration element 12 is provided with holes continuous from a distal end (the cylindrical portion 122 is present), thereby reducing the polar moment of inertia T1 at the distal end part of the second vibration element 12. According to Relational Equation (1), it is derived that the continuous location of the columnar portion 121 and the cylindrical portion 122 of the embodiment illustrated in FIG. 3B can further increase a magnification ratio of the torsional vibration.

$$(d^2\theta(x)/dx^2) + \{(dT(x)/dx)/T(x)\}(d\theta(x)/dx)$$

$$+ \mu^2\theta(x)=0 \dots (1).$$

Here, "θ(x)" represents a torsional angle of torsional vibration at a position x of the second vibration element 12 in the axial direction, "T(x)" represents a polar moment of inertia of the torsional vibration at the position x of the second vibration element 12 in the axial direction, and "μ" represents $\mu = \omega/c$ (ω: 2πf, c: acoustic velocity at which the torsional vibration is transmitted through a metal).

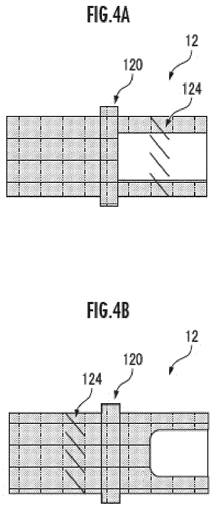

According to a modified embodiment of FIG. 3A, as illustrated in FIG. 4A, the second vibration element 12 may have the frequency adjustment element 120 provided on a proximal end side of the slit 124 (provided on the cylindrical portion 122). According to a modified embodiment of FIG. 3B, as illustrated in FIG. 4B, the second vibration element 12 may have the frequency adjustment element 120 provided on the distal end side of the slit 124 (provided on the columnar portion 121).

As illustrated in FIG. 1, the second vibration element 12 is provided with the distal end part 126 having a substantially regular octagonal shape with rounded corners, which protrudes in the radial direction over the entire circumference, at a distal end position of the second vibration element 12 in the axial direction of the second vibration element 12. The distal end part 126 has holes 128 (or through-holes) formed at a plurality of locations spaced apart from each other in a circumferential direction of the distal end part 126. N (N = 2, 3, ...) holes 128 may be disposed to have N-time rotational symmetry (for example, N = 4) about the central axis of the second vibration element 12. A female screw is provided on an inner surface of the hole 128.

The horn tip 16 has a base part having a substantially frustum shape and a distal end part that abuts on a workpiece W1, which is the uppermost workpiece of workpieces W1 and W2. A male screw provided on a proximal end part of the horn tip 16 is screwed into the female screw provided in the hole 128 of the distal end part 126 of the second vibration element 12, so that the horn tip 16 is removably fixed to the second vibration element 12. By preparing horn tips 16 having various shapes, the horn tips 16 can be appropriately replaced according to a type of metal serving as a bonding target and the like.

A male screw of a balancer for adjusting a phase difference between the longitudinal vibration and the torsional vibration in the distal end part 126 of the second vibration element 12 and the horn tip 16 is screwed into the female screw of the hole 128, so that the balancer may be removably fixed to the distal end part 126 of the second vibration element 12.

The anvil 18 is disposed facing a distal end part of the horn tip 16 in a vertical direction. For example, the workpieces W1 and W2 having a substantially flat shape are placed on an upper surface of the anvil 18 in a superimposed manner. The anvil 18 may be configured to be passively or actively displaced up and down according to a pressure of the horn tip 16 received through the workpieces W1 and W2.

As illustrated in FIG. 1, the ultrasonic bonding device further includes a control device 20, a high-frequency power supply device 21, a pressurization device 22, a stroke sensor 24, and an interface device 26.

The high-frequency power supply device 21 is configured to excite the first vibration element 11 in the axial direction by applying a high-frequency alternating current voltage to the piezoelectric body 112 of the first vibration element 11 in accordance with power supplied from a commercial power supply (not illustrated). The pressurization device 22 includes a pressurization block, and is configured to apply a pressure to the workpieces W1 and W2 from the horn tip 16 by displacing a support mechanism, such as a clamping mechanism, that supports the intermediate vibration element 10 by the pressurization block. The stroke sensor 24 outputs a signal corresponding to a displacement amount of the pressurization block constituting the pressurization device 22. The interface device 26 includes a display, for example, and displays or outputs, on or to the display, a time series of the displacement amount and/or the pressure of the pressurization block according to the output signal of the stroke sensor 24. The display may include a touch panel-type display, and may be configured to receive a setting operation for directly or indirectly designating a parameter, such as a bonding mode of a position from among a plurality of bonding modes in which a time-series pattern of a target pressure is determined by a user.

The control device 20 includes a microcomputer, and furthermore, an arithmetic processing device (CPU, microprocessor, processor core, and the like) and a storage device (memory such as a ROM and a RAM). For example, the control device 20 is configured to control a displacement operation of the pressurization block by the pressurization device 22 based on a time series of the displacement amount of the pressurization block represented by the output signal of the stroke sensor 24. In addition to the stroke sensor 24, a pressure sensor that outputs a signal corresponding to the pressure (the pressure applied to the workpiece W1 and W2 by the horn tip 16) acting on the intermediate vibration element 10 from the pressurization block of the pressurization device 22 may be provided, so that the control device 20 may control the time series of the pressure to be constant or to be in a designated mode based on the output signal of the pressure sensor.

(Action)

In response to the supply of power from the commercial power supply (not illustrated) to the high-frequency power supply device 21, the high-frequency alternating current voltage is applied to the piezoelectric body 112 of the first vibration element 11 by the high-frequency power supply device 21. As a result, the first vibration element 11 vibrates in the axial direction at, for example, about 20 kHz, and ultrasonic vibration is generated. The ultrasonic vibration is transmitted from the first vibration element 11 to the intermediate vibration element 10 in the axial direction, and an amplitude of the ultrasonic vibration is amplified. Further, the ultrasonic vibration of the amplitude that is amplified from the intermediate vibration element 10 is transmitted to the second vibration element 12 in the axial direction.

As described above, some of longitudinal vibration components (axial direction components of the second vibration element 12) of the ultrasonic vibration transmitted to the second vibration element 12 are converted into torsional vibration components by the plurality of slits 124 formed in the outer surface of the second vibration element 12. Composite vibration generated by the combination of the longitudinal vibration components and the torsional vibration components is transmitted to the horn tip 16 fixed to the distal end part 126 of the second vibration element 12.

Accordingly, the distal end part of the horn tip 16 is displaced or vibrated in a horizontal direction such that a circular orbit or an elliptical orbit is drawn. In this case, impurities on a contact surface between the workpieces W1 and W2 are eliminated, and plastic deformation of the contact surface between the workpieces W1 and W2 can be further promoted.

When the pressurization device 22 moves the first vibration element 11, the intermediate vibration element 10, and the second vibration element 12 downward, and the workpieces W1 and W2 are pressed in the vertical direction by the distal end part of the horn tip 16, circular vibration or elliptical vibration is provided in which the longitudinal vibration components and lateral vibration components are combined.

In this case, the pressurization device 22 adjusts a static pressure, which is applied from a vertical position of the horn tip 16 and the distal end part of the horn tip 16 to the workpieces W1 and W2, such that the static pressure is included in a designated static pressure range (for example, 200 N to 800 N). The workpieces W1 and W2 can be solid-phase-bonded to each other by applying the composite vibration to the workpieces W1 and W2 while adjusting the amount of pushing the workpieces W1 and W2 using the horn tip 16 and/or the static pressure applied to the workpieces W1 and W2.

(Effect)

The ultrasonic composite vibration device 1 according the configuration is configured such that a plurality of vibration elements, that is, the first vibration element 11, the intermediate vibration element 10, and the second vibration element 12 are mechanically connected in the designated connection locations which are included in the range within the phase angle of 0.05 π based on the antinodes A (N1) of the standing wave M1 of the longitudinal vibration, and are included in a range within the phase angle of 0.22 π based on the nodes N (M2) of the standing wave M2 of the torsional vibration (see FIG. 2). As a result, stability of the connection state is improved.

In an ultrasonic composite vibration system including the first vibration element 11, the intermediate vibration element 10, and the second vibration element 12 (or the first vibration element 11 and the second vibration element 12), when the torsional vibration occurs, the ultrasonic composite vibration system is largely twisted at a portion of the slit 124. This is because a lateral elastic modulus G of the ultrasonic composite vibration system is reduced at the portion of the slit 124. Since an acoustic velocity c of the torsional vibration is represented by $c = (G/\rho)^{1/2}$ using a specific gravity $\rho$, a torsional acoustic velocity c of the slit is decreased due to the decrease in G. The slit 124 is provided, and the torsional acoustic velocity c decreases, resulting in a decrease in resonance frequency. Further, the longer and/or deeper the slit 124 is, the larger the decrease in the resonance frequency is.

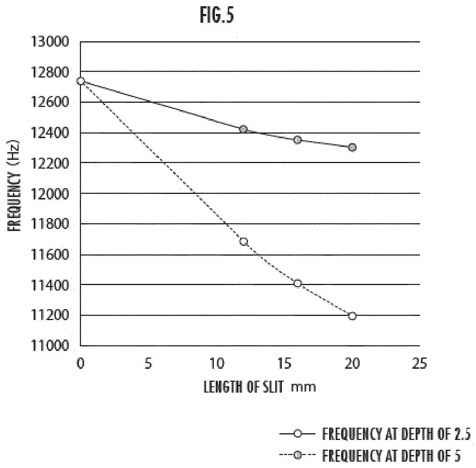

FIG. 5 illustrates a mode (simulation result) of a change in frequency (torsional resonance frequency) of the standing wave of the torsional vibration with respect to the change in depth and length of the slit 124 in the ultrasonic composite vibration system. The solid line in FIG. 5 indicates length dependence of the slit 124 of the torsional resonance frequency in the ultrasonic composite vibration system when the depth of the slit 124 is 2.5 mm. The broken line in FIG. 5 indicates length dependence of the slit 124 of the torsional resonance frequency in the ultrasonic composite vibration system when the depth of the slit 124 is 5.0 mm. The slits 124 are formed to extend in parallel with the ultrasonic composite vibration system or the axial direction of the second vibration element 12, and are disposed at equal intervals in the circumferential direction.

As illustrated in FIG. 5, a value of the length of the solid line and the broken line is 0 mm, that is, the torsional resonance frequency of the ultrasonic composite vibration system when the slit 124 is not provided is about 12.7 kHz. As indicated by the solid line in FIG. 5, as the length of the slit 124 having a depth of 2.5 mm increases from 12 mm to 16 mm and to 20 mm, the torsional resonance frequency of the ultrasonic composite vibration system decreases from about 12.42 kHz to about 12.35 kHz and to about 12.3 kHz. As indicated by the broken line in FIG. 5, as the length of the slit 124 having a depth of 5.0 mm increases from 12 mm to 16 mm and to 20 mm, the torsional resonance frequency of the ultrasonic composite vibration system decreases from about 11.68 kHz to about 11.4 kHz and to about 11.2 kHz. As the slit 124 is deeper, the torsional resonance frequency decreases as the slit 124 becomes longer.

As described above, by adjusting the depth and the length (further, a width, a shape of an opening part, the number, and/or the interval in the circumferential direction) of each of the plurality of slits 124, a position of the node N (M2) of the standing wave M2 of the torsional vibration in the ultrasonic composite vibration system is adjusted, and the position of the designated connection location is adjusted such that the phase angle is in a range within a phase angle of $0.22\pi$ based on the position.

(Second Embodiment)

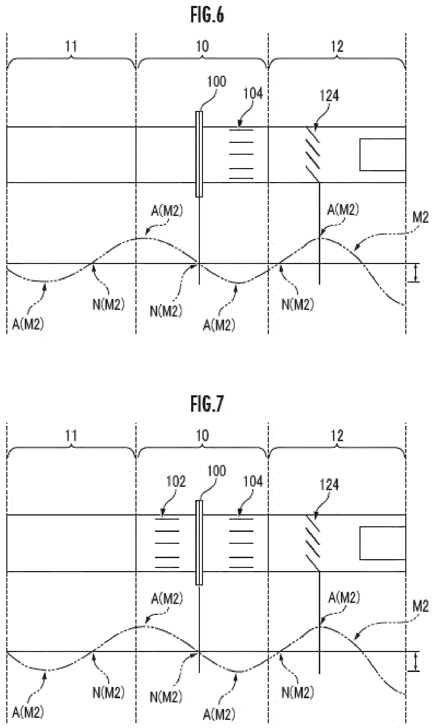

An ultrasonic composite vibration device 1 according to a second embodiment of the present invention illustrated in FIG. 6 includes a first vibration element 11, an intermediate vibration element 10, and a second vibration element 12, similarly to the ultrasonic composite vibration device 1 according to the first embodiment of the present invention illustrated in FIG. 1. The intermediate vibration element 10 is formed with a plurality of slits 104 in a substantially cylindrical front portion in front of an intermediate flange 100. The plurality of slits 104 extends linearly in parallel with a central axis of the intermediate vibration element 10, and is disposed side by side at equal intervals in a circumferential direction of the intermediate vibration element 10. Regarding other configurations, since the ultrasonic composite vibration device 1 of the second embodiment and the ultrasonic composite vibration device 1 of the first embodiment are common or almost the same, the common configurations are represented by the same reference numerals, and the description thereof will be omitted.

FIG. 6 illustrates a relationship between a configuration of the ultrasonic composite vibration device 1 and a standing wave M2 of torsional vibration generated in the ultrasonic composite vibration device 1. As illustrated in FIG. 6, one node N (M2) of the standing wave M2 of the torsional vibration coincides or overlaps with the intermediate flange 100 of the intermediate vibration element 10. This is implemented by adjusting the shape, size (length, width, and/or depth (thickness of the front portion of the intermediate vibration element 10)) of each of the plurality of slits 104 in the intermediate vibration element 10 and/or the number of slits in the circumferential direction or the interval between the slits in the circumferential direction. The shapes and sizes of the plurality of slits 104 may be the same or different from each other. In the latter case, for example, the plurality of slits 104 may be classified into a first slit group and a second slit group according to the shape and/or the size, and first slits constituting the first slit group and second slits constituting the second slit group may be alternately disposed in the circumferential direction.

(Third Embodiment)

An ultrasonic composite vibration device 1 according to a third embodiment of the present invention illustrated in FIG. 7 includes a first vibration element 11, an intermediate vibration element 10, and a second vibration element 12, similarly to the ultrasonic composite vibration device 1 according to the second embodiment of the present invention illustrated in FIG. 6. The intermediate vibration element 10 is formed with a plurality of slits 104 in a substantially cylindrical front portion in front of an intermediate flange 100. In addition, the intermediate vibration element 10 is formed with a plurality of slits 102 in a substantially cylindrical rear portion behind an intermediate flange 100. The plurality of slits 102 and 104 extend linearly in parallel with a central axis of the intermediate vibration element 10, and is disposed side by side at equal intervals in a circumferential direction of the intermediate vibration element 10. Regarding other configurations, since the ultrasonic composite vibration device 1 of the third embodiment and the ultrasonic composite vibration device 1 of the second embodiment are common or almost the same, the common configurations are represented by the same reference numerals, and the description thereof will be omitted.

FIG. 7 illustrates a relationship between a configuration of the ultrasonic composite vibration device 1 and a standing wave M2 of torsional vibration generated in the ultrasonic composite vibration device 1. As illustrated in FIG. 7, one node N (M2) of the standing wave M2 of the torsional vibration coincides or overlaps with the intermediate flange 100 of the intermediate vibration element 10. This is implemented by adjusting the shape, size (length, width, and/or depth (thickness of the substantially cylindrical portion of the intermediate vibration element 10)), and/or the number in the circumferential direction or interval in the circumferential direction of each of the plurality of slits 104 at the front portion of the intermediate vibration element 10, and/or the shape, size (length, width, and/or depth (thickness of the substantially cylindrical portion of the intermediate vibration element 10)), and/or the number in the circumferential direction or interval in the circumferential direction of each of the plurality of slits 102 at the rear portion of the intermediate vibration element 10. The shapes and sizes of the plurality of slits 102 and 104 may be the same or different from each other. In the latter case, for example, the plurality of slits 104 may be classified into a first slit group and a second slit group according to the shape and/or the size, and first slits constituting the first slit group and second slits constituting the second slit group may be alternately disposed in the circumferential direction. Alternatively or additionally, the plurality of slits 102 may be classified into a first slit group and a second slit group according to the shape and/or the size, and first slits constituting the first slit group and second slits constituting the second slit group may be alternately disposed in the circumferential direction.

(Fourth Embodiment)

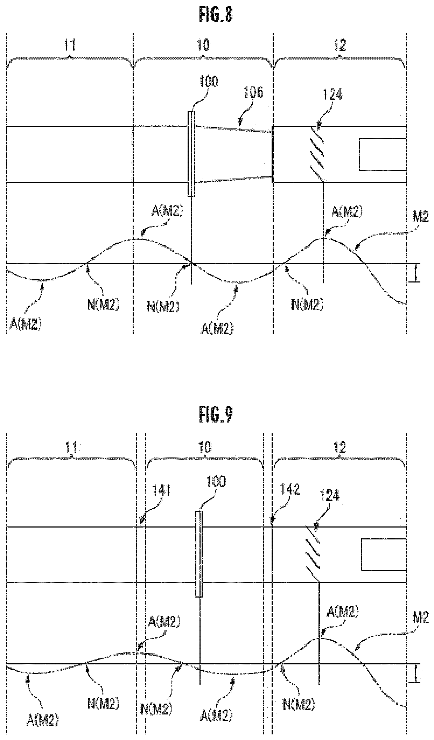

An ultrasonic composite vibration device 1 according to a fourth embodiment of the present invention illustrated in FIG. 8 includes a first vibration element 11, an intermediate vibration element 10, and a second vibration element 12, similarly to the ultrasonic composite vibration device 1 according to the first embodiment of the present invention illustrated in FIG. 1. A front portion of the intermediate vibration element 10, which is positioned in front of an intermediate flange 100, is formed to continuously reduce a diameter (in a substantially frustum shape) toward a front end part. Regarding other configurations, since the ultrasonic composite vibration device 1 of the fourth embodiment and the ultrasonic composite vibration device 1 of the first embodiment are common or almost the same, the common configurations are represented by the same reference numerals, and the description thereof will be omitted.

FIG. 8 illustrates a relationship between a configuration of the ultrasonic composite vibration device 1 and a standing wave M2 of torsional vibration generated in the ultrasonic composite vibration device 1. As illustrated in FIG. 8, one node N (M2) of the standing wave M2 of the torsional vibration coincides or overlaps with the intermediate flange 100 of the intermediate vibration element 10. This is implemented by adjusting the mode of the change in diameter with respect to a position of the substantially frustum shaped front portion of the intermediate vibration element 10 in the axial direction. A substantially frustum shaped side surface of the front portion of the intermediate vibration element 10 may be formed of a convex curved surface, a concave curved surface, or a combination of the convex curved surface and the concave curved surface.

(Fifth Embodiment)

An ultrasonic composite vibration device 1 according to a fifth embodiment of the present invention illustrated in FIG. 9 includes a first vibration element 11, an intermediate vibration element 10, and a second vibration element 12, similarly to the ultrasonic composite vibration device 1 according to the first embodiment of the present invention illustrated in FIG. 1. The first vibration element 11 and the intermediate vibration element 10 are connected with a first intermediate member 141, which has a substantially disc shape or a substantially annular plate shape with the substantially the same diameter, interposed therebetween. The second vibration element 12 and the intermediate vibration element 10 are connected with a second intermediate member 142, which has a substantially disc shape or a substantially annular plate shape with the substantially the same diameter, interposed therebetween. Regarding other configurations, since the ultrasonic composite vibration device 1 of the fifth embodiment and the ultrasonic composite vibration device 1 of the first embodiment are common or almost the same, the common configurations are represented by the same reference numerals, and the description thereof will be omitted.

FIG. 9 illustrates a relationship between a configuration of the ultrasonic composite vibration device 1 and a standing wave M2 of torsional vibration generated in the ultrasonic composite vibration device 1. As illustrated in FIG. 9, a standing wave M2 of torsional vibration is attenuated behind the slit 124 of the second vibration element 12. This is implemented by adjusting the size (inner diameter, outer diameter, and thickness) of each of the first intermediate member 141 and the second intermediate member 142. One of the first intermediate member 141 and the second intermediate member 142 may be omitted.

According to each of the second embodiment to the fourth embodiment, the first vibration element 11 and the intermediate vibration element 10 may be co-axially connected at a location different from the designated connection location. Alternatively or additionally, according to each of the second embodiment to the fourth embodiment, the intermediate vibration element 10 and the second vibration element 12 may be co-axially connected by the mechanical connection mechanism at a location different from the designated connection location.

According to the fifth embodiment, the first vibration element 11 and the first intermediate member 141 or the first intermediate member 141 and the intermediate vibration element 10 may be co-axially connected at a location different from the designated connection location. Alternatively or additionally, according to the fifth embodiment, the intermediate vibration element 10 and the second intermediate member 142 or the second intermediate member 142 and the second vibration element 12 may be co-axially connected by the mechanical connection mechanism at a location different from the designated connection location.

Description of Reference Numerals

1: ultrasonic composite vibration device
10: intermediate vibration element
100: intermediate flange
11: first vibration element
112: piezoelectric body
12: second vibration element
120: frequency adjustment element
121: columnar portion
122: cylindrical portion
124: slit
126: distal end part
128: hole
16: horn tip
18: anvil
20: control device
21: high-frequency power supply device
22: pressurization device
24: stroke sensor
26: interface device

**Claims**

1. An ultrasonic composite vibration device, which is an ultrasonic composite vibration element that induces composite vibration by synthesizing longitudinal vibration and torsional vibration, comprising:

   a first vibration element having an electrostrictive transducer that generates the longitudinal vibration; and a second vibration element having a slit and a frequency adjustment element for converting the longitudinal vibration into the torsional vibration,
   wherein the first vibration element and the second vibration element are co-axially connected at a first designated connection location which is included in a range within a phase angle of $0.05\pi$ based on antinodes of a standing wave of the longitudinal vibration, and is included in a range within a phase angle of $0.22\pi$ based on nodes of a standing wave of the torsional vibration, and the first vibration element or the second vibration element is configured to be supported in a designated support location where a node of at least one of the standing wave of the longitudinal vibration and the standing wave of the torsional vibration is present.

2. The ultrasonic composite vibration device according to Claim 1,

   wherein at least one of the first vibration element and the second vibration element includes a plurality of vibration elements, and
   the plurality of vibration elements is co-axially connected at a second designated connection location which is included in the range within the phase angle of $0.05\pi$ based on the antinodes of the standing wave of the longitudinal vibration, and is included in the range within the phase angle of $0.22\pi$ based on the nodes of the standing wave of the torsional vibration.

3. The ultrasonic composite vibration device according to Claim 1,

   wherein the second vibration element has a shape in which a columnar portion and a cylindrical portion are co-axially continuous at a location which is included in the range within the phase angle of $0.22\pi$ based on the nodes of the standing wave of the torsional vibration, and the slit is provided in the columnar portion in a range within a phase angle of $0.20\pi$ based on the nodes of the standing wave of the torsional vibration.

4. The ultrasonic composite vibration device according to Claim 3,
   wherein the frequency adjustment element is present behind the slit in the second vibration element.

5. The ultrasonic composite vibration device according to Claim 1,
   wherein the node of the standing wave of the torsional vibration is present in the designated support location.

6. The ultrasonic composite vibration device according to Claim 1,
   wherein the first vibration element and the second vibration element are co-axially connected at the first designated connection location via an intermediate member.

7. The ultrasonic composite vibration device according to Claim 2,
   wherein the plurality of vibration elements is co-axially connected at the second designated connection location via an intermediate member.

8. An ultrasonic bonding device comprising:

   the ultrasonic composite vibration device according to Claim 1;
   a horn tip attached to a distal end part of the second vibration element; and
   an anvil disposed facing the horn tip to support a workpiece serving as a bonding target.

FIG.1

# FIG.2

FIG.3A

FIG.3B

**FIG.4A**

**FIG.4B**

FIG.5

EP 4 616 966 A2

## FIG.6

## FIG.7

FIG.8

11　　　　　　10　　　　　　12

100　　106　　　124

A(M2)　　　　A(M2)　　　M2

N(M2)　　N(M2)　　N(M2)

A(M2)　　　A(M2)

FIG.9

11　　　　　　10　　　　　　12

141　　100　　142　　124

A(M2)　　　A(M2)　　　M2

N(M2)　　N(M2)　　N(M2)

A(M2)　　　A(M2)

**REFERENCES CITED IN THE DESCRIPTION**

**Patent documents cited in the description**

- JP 5036124 B